# FASCICULE DE BREVET EUROPEEN

(11) **EP 3 446 540 B1**
(45) Date de publication et mention de la délivrance du brevet: **29.07.2020**
(21) Numéro de dépôt: 17707638.7
(22) Date de dépôt: 07.02.2017
(51) Int. Cl.: H05B 1/02, F17D 1/18, F16L 53/00, H05B 3/56

(54) **INSTALLATION ÉLECTRIQUE POUR SYSTÈME DE CHAUFFAGE ÉLECTRIQUE PAR TRAÇAGE D'UNE CONDUITE MÉTALLIQUE DE TRANSPORT DE FLUIDES ET PROCÉDÉ DE CHAUFFAGE ÉLECTRIQUE PAR TRAÇAGE D'UNE TELLE CONDUITE**
ELEKTRISCHE INSTALLATION FÜR EIN ELEKTRISCHES BEGLEITHEIZUNGSSYSTEM FÜR EIN METALLROHR ZUM TRANSPORT VON FLÜSSIGKEITEN UND ELEKTRISCHES BEGLEITHEIZUNGSVERFAHREN FÜR SOLCH EIN ROHR
ELECTRICAL INSTALLATION FOR AN ELECTRIC TRACE HEATING SYSTEM FOR A METAL PIPE FOR TRANSPORTING FLUIDS AND ELECTRIC TRACE HEATING METHOD FOR SUCH A PIPE

(30) Priorité: 18.04.2016 FR 1653388
(43) Date de publication de la demande: 27.02.2019
(73) Titulaire: SAIPEM S.A., 78180 Montigny-le-Bretonneux (FR)
(72) Inventeur: PIONETTI, François-Régis, 50450 LA BALEINE (FR); AGOUMI, Jalil, 94270 LE KREMLIN-BICETRE (FR); SUNDERMANN, Axel, 91640 FONTENAY-LES-BRIIS (FR)
(74) Mandataire: Cabinet Beau de Loménie
(86) Numéro de dépôt international: PCT/FR2017/050270
(87) Numéro de publication internationale: WO 2017/182721

(56) Documents cités:
- WO-A1-88/05988
- FR-A1- 2 978 006
- FR-A1- 2 991 024
- GB-A- 2 485 647
- GB-A- 2 492 883

## Description

### Arrière-plan de l'invention

La présente invention se rapporte au domaine général du chauffage électrique par traçage des conduites métalliques de transport de fluides, et en particulier des conduites sous-marines reposant au fond de la mer et assurant une liaison entre des puits de production d'hydrocarbures sous-marins, notamment de pétrole et de gaz, et une installation de surface, par exemple une unité flottante de production, de stockage et de déchargement.

Dans un même champ de production d'hydrocarbures offshore, il est courant d'exploiter plusieurs puits qui peuvent être séparés les uns des autres de plusieurs kilomètres, voire dizaines de kilomètres. Les fluides issus de ces différents puits doivent être collectés par des conduites sous-marines métalliques (typiquement en acier) posées au fond de la mer et transférés par des conduites de liaison fond/surface vers une installation de surface, par exemple un navire ou un point de collecte terrestre, qui va les recueillir pour les stocker (et éventuellement les traiter).

Les fluides issus des puits de production ont tendance à se refroidir très rapidement en parcourant les nombreux kilomètres de conduites sous-marines. Or, si aucune disposition n'est prise pour conserver une température de seuil minimale à l'intérieur de ces conduites, le risque est important que les molécules de gaz, notamment le méthane, contenus dans les fluides transportés se combinent aux molécules d'eau pour former, à basse température, des cristaux d'hydrates. Ces derniers peuvent coller aux parois, s'y agglomérer et conduire à la formation de bouchons capables de bloquer la circulation des fluides à l'intérieur des conduites. De même, la solubilité dans le pétrole des composés à haut poids moléculaires, comme les paraffines ou les asphaltènes, diminue lorsque la température baisse, ce qui donne naissance à des dépôts solides capables eux-aussi de bloquer la circulation.

L'une des solutions connues pour tenter de remédier à ce problème consiste à chauffer les conduites grâce à des câbles électriques, ronds ou plats, qui sont enroulés autour des conduites en acier sur toute leur longueur pour chauffer ces conduites par effet Joule. La puissance électrique qui est fournie aux câbles électriques provient d'un générateur électrique externe raccordé aux câbles par un ombilical ou d'un générateur électrique directement intégré aux conduites sous-marines. Cette solution de chauffage électrique qui est appelée « chauffage par traçage » ou « chauffage tracé » (« heat tracing » en anglais) permet de maintenir les fluides transportés dans les conduites à une température supérieure à un seuil critique sur tout leur trajet depuis le puits de production jusqu'à l'installation de surface.

Typiquement, l'installation électrique utilisée pour la mise en œuvre du chauffage électrique par traçage se compose d'un ou plusieurs circuits électriques triphasés alimentés en différentes puissances par un ou plusieurs transformateurs électriques. Les circuits triphasés sont en effet parfaitement indiqués pour apporter la puissance électrique nécessaire pour chauffer la conduite sur toute la longueur de celle-ci avec le moins de pertes en ligne possible.

Pour parer à l'éventualité d'une défaillance de l'installation électrique entraînant une interruption du chauffage de la conduite sous-marine pendant sa période d'utilisation, il est connu de recourir à une redondance des circuits électriques triphasés de cette installation, cette redondance pouvant aller jusqu'à 200% (c'est-à-dire qu'il est prévu deux circuits triphasés supplémentaires de rechange par circuit triphasé utilisé). Lorsque l'un des circuits triphasés de l'installation électrique tombe en panne, il est alors remplacé par l'un des circuits de rechange. Or, la panne d'un circuit triphasé est généralement due à la défaillance d'un seul de ses câbles électriques, tandis que l'ensemble du circuit concerné se voit mis au rebut, notamment les câbles électriques non défaillant de celui-ci. Les documents FR 2 978 0006 A1, FR 2 991 924 A1, GB 2 492 883 A et GB 2 485 647 A divulguent des installations électriques selon l'art antérieur.

### Objet et résumé de l'invention

La présente invention a donc pour but principal de pallier de tels inconvénients en proposant une installation électrique qui permet d'obtenir une redondance des circuits électriques triphasés en limitant le nombre de câbles électriques de l'installation.

Conformément à l'invention, ce but est atteint grâce à une installation électrique pour système de chauffage électrique par traçage d'une conduite métallique de transport de fluides, comprenant au moins un circuit électrique polyphasé ayant :
au moins trois câbles électriques principaux couplés en étoile et destinés à être parcourus par des courants électriques ayant une même fréquence, une même amplitude et des phases différentes,
au moins un câble électrique supplémentaire distinct des câbles principaux, les câbles principaux et le câble supplémentaire du circuit polyphasé étant destinés à être positionnés autour de la conduite entre deux extrémités longitudinales de celle-ci et étant reliés en fin de ligne à un même anneau de connexion disposé autour de la conduite et formant un point de potentiel électrique nul, et
des moyens de détection d'une éventuelle panne du circuit polyphasé dans le but d'identifier le câble principal défaillant ayant entraîné la panne du circuit polyphasé et de le remplacer par le câble supplémentaire.

Lorsqu'une panne du circuit polyphasé de l'installation selon l'invention est détectée, il est prévu d'identifier le câble principal défaillant ayant entraîné la panne du circuit polyphasé et de le remplacer par le câble supplémentaire. Ainsi, en cas de défaillance de l'un des câbles principaux du circuit polyphasé entraînant une panne de ce dernier, seul le câble principal défaillant est, selon l'invention, déconnecté du circuit et remplacé par le câble supplémentaire du circuit. Ce remplacement est rendu possible grâce notamment au raccordement en fin de ligne des câbles principaux et du câble supplémentaire au même potentiel électrique nul (à savoir l'anneau de connexion disposé autour de la conduite). De la sorte, en cas de panne d'un circuit polyphasé, comme seul le câble électrique défaillant est remplacé, il est possible d'éviter une mise au rebut inutile des câbles électriques non défaillant.

En particulier, si le circuit polyphasé est un circuit triphasé (c'est-à-dire comprenant trois câbles principaux alimentés en courants déphasés entre eux d'un tiers de tour), un seul câble supplémentaire suffit à assurer une redondance à 100% du circuit (deux câbles supplémentaires permettent d'obtenir une redondance de 200%, etc.). Par rapport à l'art antérieur dans lequel une redondance de 100% est obtenue grâce à l'ajout d'un circuit triphasé supplémentaire complet, l'invention permet ainsi de réduire d'un tiers le nombre de câbles électriques supplémentaires pour parvenir à la même redondance. Inversement, avec un circuit triphasé supplémentaire complet, l'invention permet d'obtenir une redondance de 300% (à la place d'une redondance de seulement 100% avec l'art antérieur).

Le câble supplémentaire du circuit polyphasé peut être raccordé à un neutre dudit circuit polyphasé, les moyens de détection d'une éventuelle panne du circuit polyphasé comprenant alors des moyens de contrôle de l'intensité du courant électrique parcourant le câble supplémentaire raccordé au neutre du circuit polyphasé. Lorsque le circuit polyphasé est équilibré (c'est-à-dire que les courants parcourant les câbles principaux du circuit ont la même amplitude), le courant électrique parcourant le neutre du circuit est quasiment nul (et inférieur à 1% du courant passant par les câbles principaux). Aussi, cette solution présente l'avantage de pouvoir détecter une éventuelle panne du circuit polyphasé en contrôlant uniquement le niveau d'intensité du courant parcourant ce câble supplémentaire : en cas de défaut du circuit polyphasé, l'intensité du courant parcourant le câble supplémentaire augmentera sensiblement.

Alternativement, le câble supplémentaire du circuit polyphasé peut être un câble de rechange déconnecté électriquement du circuit polyphasé.

Quel que soit le raccordement du câble supplémentaire, les moyens de détection d'une éventuelle panne du circuit polyphasé peuvent comprendre des moyens de contrôle de l'intensité du courant électrique parcourant chacun des câbles principaux du circuit polyphasé. Dès qu'une variation de l'intensité du courant parcourant un câble principal est détectée (soit cette intensité passe à zéro, soit elle devient anormalement élevée), le câble principal en question est considéré comme défaillant et l'opérateur coupe le circuit polyphasé, déconnecte le câble principal défaillant, et le remplace par le câble supplémentaire.

La conduite peut être reliée électriquement en fin de ligne à l'anneau de connexion. Dans ce cas, l'anneau de connexion peut comprendre une pluralité de languettes en contact électrique avec la conduite, l'installation comprenant en outre une bande annulaire de serrage des languettes sur ladite conduite. Alternativement, la conduite peut être reliée électriquement à un neutre du circuit polyphasé.

De préférence, le circuit polyphasé est un circuit triphasé équilibré couplé en étoile.

L'invention a également pour objet un système de chauffage électrique d'une conduite métallique de transport de fluides comprenant une installation électrique telle que définie précédemment et au moins un générateur électrique pour alimenter en courant électrique les câbles principaux du circuit polyphasé.

L'invention a encore pour objet un procédé de chauffage électrique par traçage d'une conduite métallique de transport de fluides, comprenant :
le positionnement autour de la conduite entre deux extrémités longitudinales de celle-ci d'au moins trois câbles électriques principaux couplés en étoile formant un circuit polyphasé et d'au moins un câble électrique supplémentaire ;
le raccordement des câbles principaux en tête de ligne à un générateur électrique ;
le raccordement des câbles principaux et du câble supplémentaire en fin de ligne à un même anneau de connexion disposé autour de la conduite et formant un point de potentiel électrique nul ;
la détection d'une éventuelle panne du circuit polyphasé dans le but d'identifier le câble principal défaillant ayant entraîné la panne du circuit polyphasé, et, le cas échéant, le remplacement du câble principal défaillant par le câble supplémentaire.

### Brève description des dessins

D'autres caractéristiques et avantages de la présente invention ressortiront de la description faite ci-dessous, en référence aux dessins annexés qui en illustrent un exemple de réalisation dépourvu de tout caractère limitatif. Sur les figures :
- la figure 1 illustre de façon très schématique un exemple d'installation pour système de chauffage par traçage selon l'invention ;
- la figure 2 est une vue partielle et en perspective d'une conduite équipée d'une installation électrique selon l'invention ;
- la figure 3 est une vue en coupe de la figure 2 montrant plus précisément la connexion en fin de ligne d'un câble à l'anneau de connexion de l'installation électrique ;
- la figure 4 est une vue en coupe transversale de la conduite de la figure 2 ; et
- la figure 5 est une vue en perspective de l'anneau de connexion de l'installation électrique des figures 2 à 4.

### Description détaillée de l'invention

L'invention s'applique au chauffage électrique par traçage (ou « heat tracing » en anglais) de toute conduite métallique terrestre ou sous-marine de transport de fluides, et notamment au chauffage électrique par traçage des conduites sous-marines en acier reposant au fond de la mer et assurant un transport entre des puits de production d'hydrocarbures sous-marins, notamment de pétrole et de gaz, et une installation de surface.

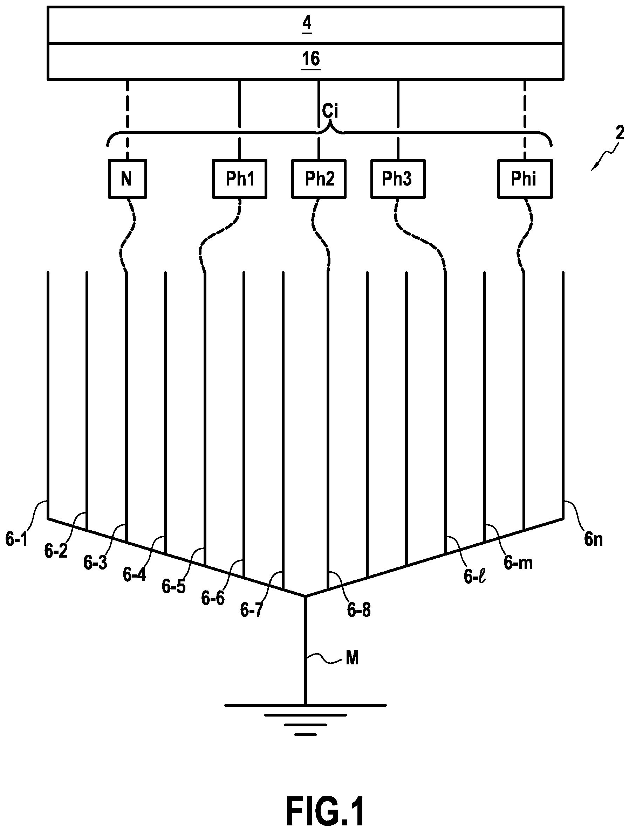

Le chauffage par traçage d'une conduite métallique de transport de fluides consiste à utiliser une installation électrique telle que celle illustrée de façon très schématique sur la figure 1, cette installation électrique 2 comprenant un ou plusieurs circuits électriques polyphasés Cⱼ qui sont alimentés en puissance électrique depuis un ou plusieurs générateurs électriques 4.

Selon l'invention, l'installation électrique pour le système de chauffage électrique par traçage de la conduite comprend, pour chaque circuit électrique polyphasé Cⱼ, n câbles électriques 6-1, 6-2, ..., 6-n, n étant un nombre entier supérieur ou égal à p+1, avec p correspondant au nombre de phases du circuit Cⱼ (p étant au moins égal à 3). Ces n câbles électriques sont positionnés autour de la conduite de transport de fluide entre les deux extrémités longitudinales de celle-ci.

Parmi ces n câbles électriques 6-1, 6-2, ..., 6-n, certains sont raccordés en tête de ligne au générateur électrique 4 pour former les différentes phases Ph1, Ph2, Ph3, ..., Phi du circuit polyphasé Cⱼ.

Les câbles électriques (à savoir les câbles 6-5, 6-8, 6-l et 6-m sur l'exemple de la figure 1) raccordés en tête de ligne au générateur électrique pour former les phases du circuit polyphasé sont appelés ci-après câbles principaux, tandis que les autres câbles sont appelés câbles supplémentaires.

Un ou plusieurs câbles électriques parmi les câbles électriques supplémentaires peut servir de neutre si cette connexion neutre est prévue sur le générateur électrique 4. Ainsi, sur l'exemple représenté sur la figure 1, le câble électrique 6-3 est un câble raccordé à un neutre N du circuit polyphasé Cⱼ.

Quant aux autres câbles électriques supplémentaires non raccordés au neutre du générateur électrique 4, ils servent de câbles de rechange en cas de panne du circuit polyphasé comme il sera décrit ultérieurement en détails.

Toujours selon l'invention, tous les n câbles électriques 6-1, 6-2, ..., 6-n de l'installation électrique sont reliés en fin de ligne à un même anneau de connexion (non représenté sur la figure 1) qui est disposé autour de la conduite de transport de fluide et qui forme un point de potentiel électrique nul.

Par ailleurs, les n câbles électriques de l'installation électrique peuvent également être reliés à la masse comme représenté par la connexion M sur la figure 1.

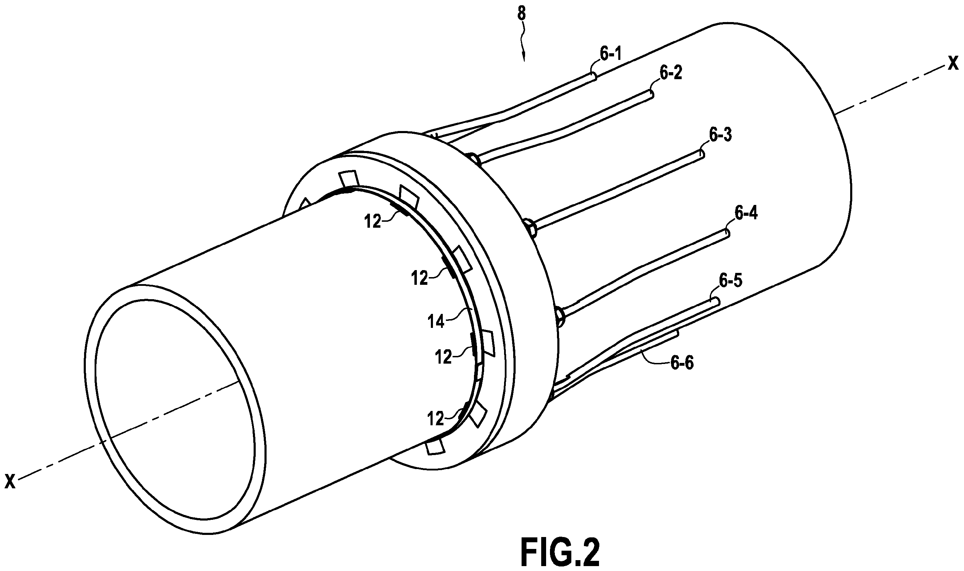

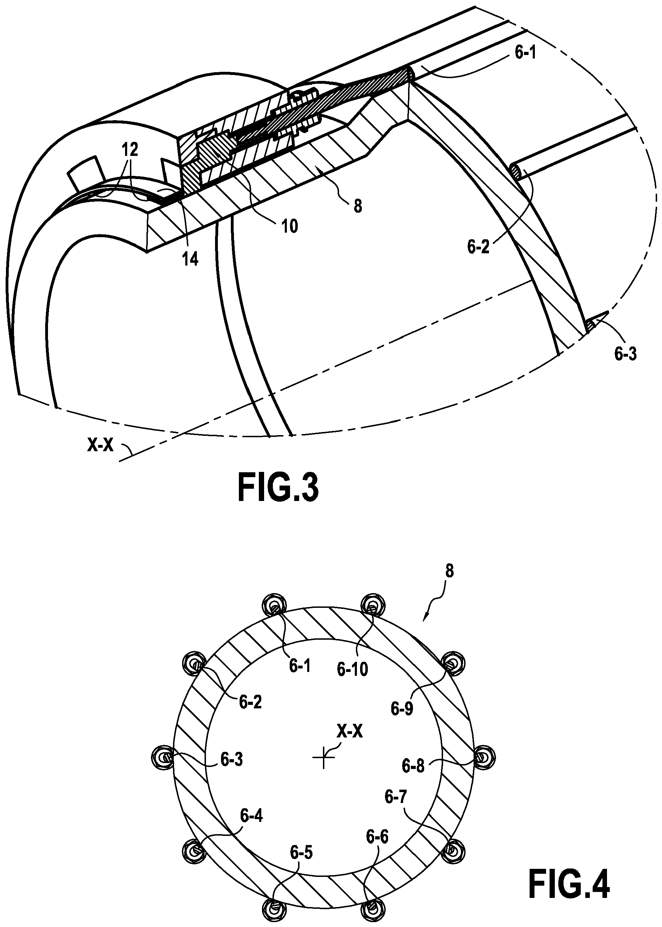

Les figures 2 à 5 représentent un exemple de mise en œuvre de l'installation électrique selon l'invention telle que décrite précédemment pour le chauffage électrique par traçage d'une conduite 8 sous-marine de transport d'hydrocarbures (la conduite est ici en acier).

Dans cet exemple de réalisation, l'installation électrique du système de chauffage électrique par traçage comprend dix câbles électriques 6-1, 6-2, ..., 6-10 (ronds ou plats) qui sont positionnés autour de la conduite 8 entre les deux extrémités longitudinales de celle-ci et en étant régulièrement répartis autour de l'axe longitudinal X-X. Ces câbles électriques sont typiquement collés sur la surface externe de la conduite et peuvent être disposés en hélice autour de l'axe longitudinal X-X de la conduite.

La composition de ces câbles électriques est connue de l'homme du métier et ne sera donc pas décrite ici. Les câbles électriques, qu'ils soient utilisés comme des câbles principaux ou comme des câbles supplémentaires, ont tous la même composition.

Toujours sur l'exemple de réalisation des figures 2 à 5, parmi les dix câbles électriques de l'installation électrique, trois câbles électriques (par exemple les câbles 6-1, 6-4 et 6-7) sont raccordés en tête de ligne au générateur électrique (non représenté sur ces figures) pour former les trois phases d'un même circuit triphasé (ce sont les câbles principaux).

L'installation électrique comprend donc également sept câbles électriques supplémentaires, à savoir les câbles 6-2, 6-3, 6-5, 6-6, 6-8 et 6-9 qui sont distincts des trois câbles électriques 6-1, 6-4 et 6-7 raccordés au générateur électrique pour former les phases du circuit triphasé.

En d'autres termes, l'installation électrique comprend ici dix câbles électriques (n=10) dont trois sont raccordés en tête de ligne au générateur électrique pour former un circuit triphasé (p=3) et sept ne sont pas raccordés au générateur électrique.

Ainsi, avec simplement dix câbles électriques 6-1 à 6-10, l'installation électrique de ce mode de réalisation comprend un circuit triphasé pourvu d'une redondance de 600%, ce qui est généralement bien plus élevé que requis.

Les câbles principaux 6-1, 6-4 et 6-7 du circuit triphasé sont couplés en étoile et destinés à être parcourus par des courants électriques ayant une même fréquence et des phases différentes. De préférence, ce circuit triphasé est équilibré, c'est-à-dire que les courants parcourant les câbles principaux du circuit ont également la même amplitude.

Au niveau de la fin de ligne (opposée à la tête de ligne), les câbles électriques principaux (à savoir les câbles 6-1, 6-4 et 6-7) et les câbles électriques supplémentaires (à savoir les câbles 6-2, 6-3, 6-5, 6-6, 6-8 et 6-9) sont tous reliés à un même anneau de connexion 10 disposé autour de la conduite 8 et formant un point de potentiel électrique nul.

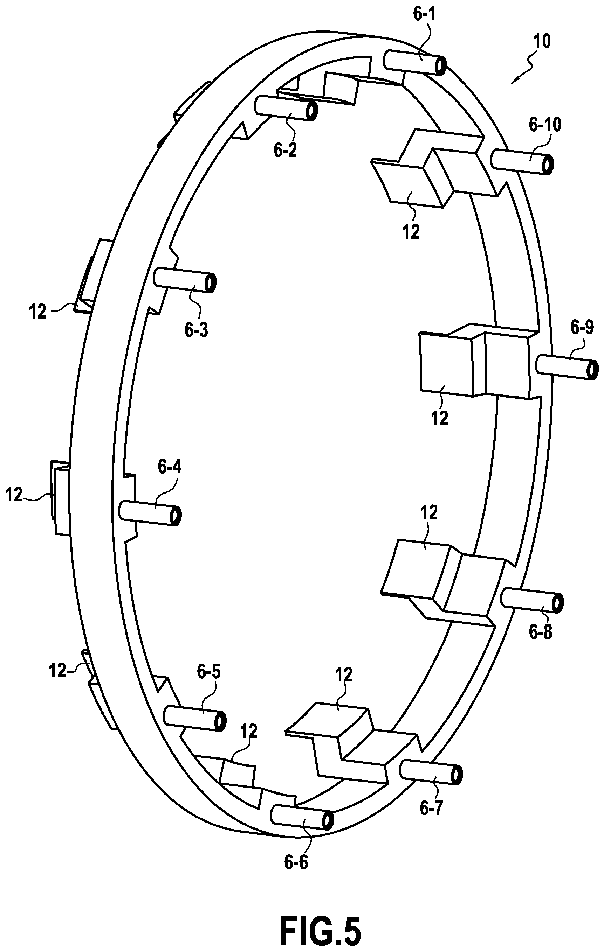

Comme représenté plus précisément sur la figure 5, cet anneau de connexion 10 est par exemple un anneau métallique qui est centré sur l'axe longitudinal X-X de la conduite et qui est raccordé électriquement à l'extrémité des câbles principaux et supplémentaires opposées à la tête de ligne (c'est-à-dire à l'extrémité opposée à l'extrémité raccordée au générateur électrique 4). La forme de l'anneau de connexion 10 peut varier en fonction de la forme de la conduite : elle peut être circulaire, cylindrique, carré, etc.

Par ailleurs, dans le mode de réalisation des figures 2 à 5, l'anneau de connexion 10 comprend une pluralité de languettes 12 permettant une mise en contact électrique de l'anneau de connexion avec la conduite en acier 8. Par exemple, les languettes 12 peuvent être aussi nombreuses que les câbles de l'installation électrique et régulièrement réparties autour de l'axe longitudinal X-X de la conduite. Dans le cas de la présence de telles languettes, il est avantageusement prévu de positionner une bande annulaire de serrage 14 des languettes 12 de l'anneau de connexion sur la conduite.

Il n'est toutefois pas indispensable de relier électriquement la conduite 8 à l'anneau de connexion 10, auquel cas il sera prévu de disposer un joint d'isolation (non représenté sur les figures) entre l'anneau de connexion et la conduite.

L'installation électrique selon l'invention comprend encore des moyens 16 (figure 1) de détection d'une éventuelle panne du circuit polyphasé Cⱼ dans le but d'identifier le câble principal (à savoir les câbles 6-1, 6-4 et 6-7 dans l'exemple de réalisation des figures 2 à 5) défaillant ayant entraîné la panne du circuit polyphasé et de le remplacer par l'un des câbles supplémentaires (à savoir les câbles 6-2, 6-3, 6-5, 6-6, 6-8 et 6-9 dans l'exemple de réalisation des figures 2 à 5).

De préférence, ces moyens 16 comprennent des moyens connus de contrôle de l'intensité du courant électrique parcourant chacun des câbles principaux du circuit polyphasé. Ce contrôle est couramment effectué dans les installations électriques pour le chauffage par traçage d'une conduite de transport de fluide afin de vérifier en continu le bon fonctionnement des circuits électriques de cette installation.

Typiquement, de tels moyens de contrôle 16 comprennent un analyseur de circuit polyphasé à boucle ampérométrique qui permet de connaître pour chaque phase et chaque neutre du circuit polyphasé l'intensité du courant et de la tension, les puissances consommées (puissance active, réactive et globale), et l'angle de déphasage entre la tension et le courant. Ces moyens comprennent également un ohmmètre.

Comme décrit précédemment, un ou plusieurs câbles supplémentaires du circuit polyphasé Cⱼ de l'installation électrique selon l'invention peuvent être raccordés à un neutre N dudit circuit polyphasé. Ce ou ces câbles supplémentaires constituent ainsi des conducteurs neutres du circuit polyphasé.

Lorsque le circuit polyphasé Cⱼ est équilibré (c'est-à-dire que les courants parcourant les câbles principaux du circuit ont la même amplitude), le courant électrique parcourant le neutre du circuit Cⱼ est quasiment nul (et inférieur à 1% du courant passant par les câbles principaux). Aussi, cette solution consistant à raccorder le ou les câbles supplémentaires du circuit à un neutre présente l'avantage de pouvoir détecter une éventuelle panne du circuit polyphasé en contrôlant uniquement le niveau d'intensité du courant parcourant ce ou ces câbles supplémentaires : dans ce cas, en cas de défaut du circuit polyphasé, l'intensité du courant parcourant le câble supplémentaire augmentera sensiblement.

Dans ce mode de réalisation, les moyens de détection d'une éventuelle panne du circuit polyphasé comprennent alors des moyens de contrôle de l'intensité du courant électrique parcourant le ou les câbles supplémentaires raccordés au neutre du circuit polyphasé. Ces moyens de contrôle sont identiques à ceux décrits ci-dessus.

Dans un autre mode de réalisation, le ou les câbles supplémentaires du circuit polyphasé Cⱼ de l'installation selon l'invention sont déconnectés électriquement du circuit polyphasé (en particulier, ils ne sont pas raccordés au neutre du circuit). Ce ou ces câbles supplémentaires constituent ainsi des câbles de rechange du circuit polyphasé.

Dans ce mode de réalisation, les moyens de détection d'une éventuelle panne du circuit polyphasé sont constitués par les moyens de contrôle de l'intensité du courant électrique parcourant chacun des câbles principaux du circuit polyphasé comme décrit précédemment.

Le fonctionnement de l'installation électrique selon l'invention est le suivant.

Lorsque le ou les câbles supplémentaires de chaque circuit polyphasé de l'installation électrique sont raccordés au neutre du circuit polyphasé, l'intensité du courant électrique parcourant ce ou ces câbles supplémentaires est contrôlée en continu. Dès que l'intensité de l'un de ces câbles supplémentaires augmente sensiblement, l'opérateur en charge de la surveillance est averti d'une panne du circuit polyphasé en question. Pour connaître le câble principal défaillant à l'origine de la panne du circuit polyphasé, l'opérateur contrôlera l'intensité parcourant chacun de ces câbles afin de vérifier leur bon fonctionnement. Une fois le câble principal défaillant identifié (câble en surtension ou en coupure), l'opérateur coupe le circuit polyphasé et remplace le câble principal défaillant par l'un des câbles supplémentaires avant de rebrancher le circuit. Cette opération de remplacement s'effectue par un simple raccordement du câble supplémentaire au générateur électrique (notamment sans avoir à retirer le câble principal défaillant).

Lorsque le ou les câbles supplémentaires de chaque circuit polyphasé de l'installation électrique sont déconnectés électriquement du circuit polyphasé, l'intensité du courant électrique parcourant les câbles principaux constituant ce circuit polyphasé est contrôlée en continu. Dès que l'intensité de l'un de ces câbles principaux augmente sensiblement, l'opérateur en charge de la surveillance est averti d'une panne du circuit polyphasé en question, coupe le circuit et remplace comme indiqué précédemment le câble principal défaillant à l'origine de la panne par l'un des câbles supplémentaires avant de rebrancher le circuit.

On notera que lorsque la défaillance d'un câble principal du circuit polyphasé est une mise à terre en un point quelconque du câble, la partie du câble qui relie le défaut au générateur électrique est toujours opérationnelle. Si la position du défaut (mise à terre) est située à proximité de l'anneau de connexion, la perte d'efficacité du câble est proportionnelle au ratio de la longueur de la partie défaillante par rapport à la longueur totale du câble, de sorte que ce câble pourrait éventuellement servir de câble de rechange en ultime recours (bien qu'il soit recommandé de le mettre au rebut). La position du défaut peut aisément être déterminée en comparant l'intensité du courant parcourant le câble avec l'intensité initiale.

On notera également qu'il est possible d'évaluer la résistance (et donc la fonctionnalité à jouer le rôle de rechange) d'un câble supplémentaire du circuit polyphasé en le raccordant au neutre du circuit polyphasé. En effet, lorsqu'il est raccordé au neutre, un très faible courant parcourt le câble, ce qui permet de mesurer sa résistance et d'en déduire sa capacité à servir de câble de rechange au cours de sa durée de vie.

On notera encore que l'installation électrique selon l'invention peut comporter plusieurs circuits polyphasés différents auquel cas les n câbles électriques sont raccordés en tête de ligne pour certains à différents générateurs électriques délivrant des puissances différentes. Par exemple, on pourra avoir une installation électrique comprenant un premier circuit triphasé alimenté par une tension de 5kV et un second circuit triphasé alimenté par une tension de 7kV. Dans ce cas, les différents circuits polyphasés sont raccordés en fin de ligne au même anneau de connexion formant le point de potentiel électrique nul.

L'installation électrique selon l'invention pour le système de chauffage électrique par traçage a été décrite ci-avant en rapport avec une conduite sous-marine de type « Single Pipe », c'est-à-dire ne comportant qu'un seul tube en contact direct avec l'eau environnante et à l'intérieur duquel circulent les hydrocarbures à transporter.

Bien entendu, l'invention s'applique également aux conduites sous-marines de type PIP (pour « Pipe In Pipe », soit « conduite dans la conduite »), c'est-à-dire aux conduites comportant un tube interne en acier à l'intérieur duquel circulent les hydrocarbures à transporter et un tube externe en acier disposé coaxialement autour du tube interne et en contact direct avec l'eau environnante. Dans cette application aux conduites de type PIP, les câbles électriques des circuits polyphasés de l'installation du système de chauffage électrique par traçage sont positionnés autour du tube interne des conduites.

## Revendications

1. Installation électrique (2) pour système de chauffage électrique par traçage d'une conduite (8) métallique de transport de fluides, comprenant un anneau de connexion (10) et au moins un circuit électrique polyphasé (Cⱼ) ayant :
au moins trois câbles électriques (6-1, 6-4 et 6-7) principaux couplés en étoile et destinés à être parcourus par des courants électriques ayant une même fréquence, une même amplitude et des phases différentes, **caractérisée par**
au moins un câble électrique supplémentaire (6-2, 6-3, 6-5, 6-6, 6-8 et 6-9) distinct des câbles principaux, les câbles principaux et le câble supplémentaire du circuit polyphasé étant destinés à être positionnés autour de la conduite entre deux extrémités longitudinales de celle-ci et étant reliés en fin de ligne à un même anneau de connexion (10) disposé autour de la conduite et formant un point de potentiel électrique nul, et
des moyens (16) de détection d'une éventuelle panne du circuit polyphasé dans le but d'identifier le câble principal défaillant ayant entraîné la panne du circuit polyphasé et de le remplacer par le câble supplémentaire.

2. Installation selon la revendication 1, dans laquelle le câble supplémentaire du circuit polyphasé est raccordé à un neutre (N) dudit circuit polyphasé, les moyens de détection d'une éventuelle panne du circuit polyphasé comprenant des moyens de contrôle de l'intensité du courant électrique parcourant le câble supplémentaire raccordé au neutre du circuit polyphasé.

3. Installation selon la revendication 1, dans laquelle le câble supplémentaire du circuit polyphasé est un câble de rechange déconnecté électriquement du circuit polyphasé.

4. Installation selon l'une quelconque des revendications 1 à 3, dans laquelle les moyens de détection d'une éventuelle panne du circuit polyphasé comprennent des moyens de contrôle de l'intensité du courant électrique parcourant chacun des câbles principaux du circuit polyphasé.

5. Installation selon l'une quelconque des revendications 1 à 4, dans laquelle l'anneau de connexion est relié électriquement en fin de ligne à la conduite.

6. Installation selon la revendication 5, dans laquelle l'anneau de connexion comprend une pluralité de languettes (12) en contact électrique avec la conduite, l'installation comprenant en outre une bande annulaire (14) de serrage des languettes sur ladite conduite.

7. Installation selon l'une quelconque des revendications 1 à 5, dans laquelle un neutre (N) du circuit polyphasé est relié à la conduite (8).

8. Installation selon l'une quelconque des revendications 1 à 7, dans laquelle le circuit polyphasé est un circuit triphasé équilibré couplé en étoile.

9. Système de chauffage électrique d'une conduite métallique de transport de fluides comprenant une installation électrique (2) selon l'une quelconque des revendications 1 à 8 et au moins un générateur électrique (4) pour alimenter en courant électrique les câbles principaux du circuit polyphasé.

10. Procédé de chauffage électrique par traçage d'une conduite (8) métallique de transport de fluides, comprenant :
le positionnement autour de la conduite entre deux extrémités longitudinales de celle-ci d'au moins trois câbles électriques principaux (6-1, 6-4 et 6-7) couplés en étoile formant un circuit polyphasé et d'au moins un câble électrique supplémentaire (6-2, 6-3, 6-5, 6-6, 6-8 et 6-9) ;
le raccordement des câbles principaux en tête de ligne à un générateur électrique (4) ;
le raccordement des câbles principaux et du câble supplémentaire en fin de ligne à un même anneau de connexion (10) disposé autour de la conduite et formant un point de potentiel électrique nul ; et
la détection d'une éventuelle panne du circuit polyphasé dans le but d'identifier le câble principal défaillant ayant entraîné la panne du circuit polyphasé, et, le cas échéant, le remplacement du câble principal défaillant par le câble supplémentaire.

11. Procédé selon la revendication 10, dans lequel le câble supplémentaire du circuit polyphasé est raccordé à un neutre (N) dudit circuit polyphasé, la détection d'une éventuelle panne du circuit polyphasé comprenant le contrôle de l'intensité du courant électrique parcourant le câble supplémentaire formant conducteur neutre du circuit polyphasé.

12. Procédé selon la revendication 10, dans lequel le câble supplémentaire du circuit polyphasé est un câble de rechange déconnecté électriquement dudit circuit polyphasé, la détection d'une éventuelle panne du circuit polyphasé comprenant le contrôle de l'intensité du courant électrique parcourant chacun des câbles principaux du circuit polyphasé.

13. Procédé selon l'une quelconque des revendications 10 à 12, comprenant en outre le raccordement électrique en fin de ligne de la conduite à l'anneau de connexion.

## Patentansprüche

1. Elektrische Installation (2) für ein elektrisches Begleitheizungssystem eines Metallrohres (8) zum Transport von Fluiden, die einen Verbindungsring (10) und mindestens einen mehrphasigen Stromkreis (Cⱼ) umfasst und aufweist:
mindestens drei elektrische Hauptkabel (6-1, 6-4 und 6-7), die sternförmig geschaltet und dazu bestimmt sind, von elektrischen Strömen durchflossen zu werden, die die gleiche Frequenz, die gleiche Amplitude und unterschiedliche Phasen aufweisen, **gekennzeichnet durch**
mindestens ein zusätzliches elektrisches Kabel (6-2, 6-3, 6-5, 6-6, 6-8 und 6-9), das sich von den Hauptkabeln unterscheidet, wobei die Hauptkabel und das zusätzliche Kabel des mehrphasigen Kreises dazu bestimmt sind, um das Rohr herum zwischen zwei Längsenden davon positioniert zu sein, und am Leitungsende mit einem selben Verbindungsring (10) verbunden sind, der um das Rohr herum angeordnet ist und einen elektrischen Nullpotentialpunkt bildet, und
Mittel (16) zur Detektion eines etwaigen Ausfalls des mehrphasigen Kreises mit dem Ziel, das defekte Hauptkabel zu identifizieren, das den Ausfall des mehrphasigen Kreises verursacht hat, und es durch das zusätzliche Kabel zu ersetzen.

2. Installation nach Anspruch 1, wobei das zusätzliche Kabel des mehrphasigen Kreises an einen Nullleiter (N) des mehrphasigen Kreises angeschlossen ist und die Mittel zur Detektion eines etwaigen Ausfalls des mehrphasigen Kreises Mittel zur Kontrolle der Stärke des elektrischen Stroms umfassen, der durch das zusätzliche Kabel fließt, das an den Neutralleiter des mehrphasigen Kreises angeschlossen ist.

3. Installation nach Anspruch 1, wobei das zusätzliche Kabel des mehrphasigen Kreises ein Ersatzkabel ist, das elektrisch von dem mehrphasigen Kreis getrennt ist.

4. Installation nach einem der Ansprüche 1 bis 3, wobei die Mittel zur Detektion eines etwaigen Ausfalls des mehrphasigen Kreises Mittel zur Kontrolle der Stärke des elektrischen Stroms umfassen, der durch jedes der Hauptkabel des mehrphasigen Kreises fließt.

5. Installation nach einem der Ansprüche 1 bis 4, wobei der Verbindungsring elektrisch am Leitungsende mit dem Rohr verbunden ist.

6. Installation nach Anspruch 5, wobei der Verbindungsring mehrere Zungen (12) umfasst, die mit dem Rohr elektrisch in Kontakt sind, wobei die Installation ferner ein ringförmiges Band (14) zum Klemmen der Zungen auf das Rohr umfasst.

7. Installation nach einem der Ansprüche 1 bis 5, wobei ein Neutralleiter (N) des mehrphasigen Kreises mit dem Rohr (8) verbunden ist.

8. Installation nach einem der Ansprüche 1 bis 7, wobei der mehrphasige Kreis ein in Stern geschalteter symmetrischer dreiphasiger Kreis ist.

9. Elektrisches Heizungssystem für ein Metallrohr zum Transport von Fluiden, das eine elektrische Installation (2) nach einem der Ansprüche 1 bis 8 und mindestens einen elektrischen Generator (4) zum Versorgen der Hauptkabel des mehrphasigen Kreises mit elektrischem Strom umfasst.

10. Elektrisches Begleitheizungsverfahren für ein Metallrohr (8) zum Transport von Fluiden, umfassend:
das Positionieren von mindestens drei elektrischen Hauptkabeln (6-1, 6-4 und 6-7), die in Stern geschaltet sind und einen mehrphasigen Kreis bilden, und von mindestens einem zusätzlichen elektrischen Kabel (6-2, 6-3, 6-5, 6-6, 6-8 und 6-9) um das Rohr herum zwischen zwei Längsenden davon,
den Anschluss der Hauptkabel am Leitungsanfang an einen elektrischen Generator (4),
den Anschluss der Hauptkabel und des zusätzlichen Kabels am Leitungsende an einen selben Verbindungsring (10), der um das Rohr herum angeordnet ist und einen elektrischen Nullpotentialpunkt bildet, und
die Detektion eines etwaigen Ausfalls des mehrphasigen Kreises mit dem Ziel, das defekte Hauptkabel zu identifizieren, das den Ausfall des mehrphasigen Kreises verursacht hat, und gegebenenfalls die Ersetzung des defekten Hauptkabels durch das zusätzliche Kabel.

11. Verfahren nach Anspruch 10, wobei das zusätzliche Kabel des mehrphasigen Kreises an einen Neutralleiter (N) des mehrphasigen Kreises angeschlossen ist und die Detektion eines etwaigen Ausfalls des mehrphasigen Kreises die Kontrolle der Stärke des elektrischen Stroms umfasst, der durch das zusätzliche Kabel fließt, das den Neutralleiter des mehrphasigen Kreises bildet.

12. Verfahren nach Anspruch 10, wobei das zusätzliche Kabel des mehrphasigen Kreises ein Ersatzkabel ist, das elektrisch von dem mehrphasigen Kreis getrennt ist und die Detektion eines etwaigen Ausfalls des mehrphasigen Kreises die Kontrolle der Stärke des elektrischen Stroms umfasst, der durch jedes der Hauptkabel des mehrphasigen Kreises fließt.

13. Verfahren nach einem der Ansprüche 10 bis 12, das ferner den elektrischen Anschluss am Leitungsende des Rohres an den Verbindungsring umfasst.

## Claims

1. An electrical installation (2) for an electrical system for trace heating a fluid transport pipe (8) made of metal, comprising a connection ring (10) and at least one polyphase electric circuit (Cⱼ) having:
at least three main electric cables (6-1, 6-4, and 6-7) in a star connection for conveying electric currents having the same frequency, the same amplitude, and different phases;
at least one additional electric cable (6-2, 6-3, 6-5, 6-6, 6-8, and 6-9) distinct from the main cables, the main cables and the additional cable of the polyphase circuit being for positioning around the pipe between two longitudinal ends thereof, and being connected at the pipeline end to a common connection ring (10) arranged around the pipe and forming a point of zero electric potential; and
detection means (16) for detecting a failure, if any, of the polyphase circuit in order to identify the failed main cable that has given rise to the failure of the polyphase circuit and in order to replace it with the additional cable.

2. An installation according to claim 1, wherein the additional cable of the polyphase circuit is connected to a neutral connection (N) of said polyphase circuit, the means for detecting a failure, if any, of the polyphase circuit comprising means for monitoring the magnitude of the electric current flowing in the additional cable connected to the neutral connection of the polyphase circuit.

3. An installation according to claim 1, wherein the additional cable of the polyphase circuit is a spare cable that is electrically disconnected from the polyphase circuit.

4. An installation according to any one of claims 1 to 3, wherein the means for detecting a failure, if any, of the polyphase circuit comprise means for monitoring the magnitude of the electric current flowing in each of the main cables of the polyphase circuit.

5. An installation according to any one of claims 1 to 4, wherein the connection ring is electrically connected to the pipeline end of the pipe.

6. An installation according to claim 5, wherein the connection ring includes a plurality of tongues (12) in electrical contact with the pipe, the installation further comprising an annular clamping band (14) for clamping the tongues against said pipe.

7. An installation according to any one of claims 1 to 5, wherein a neutral connection (N) of the polyphase circuit is connected to the pipe (8).

8. An installation according to any one of claims 1 to 7, wherein the polyphase circuit is a balanced three-phase circuit in a star connection.

9. A system for electrically heating a fluid transport pipe made of metal, the system comprising an electrical installation (2) according to any one of claims 1 to 8 and at least one electricity generator (4) for electrically powering the main cables of the polyphase circuit.

10. A method of electrically trace heating a fluid transport pipe (8) made of metal, the method comprising:
positioning around the pipe between two longitudinal ends thereof at least three main electric cables (6-1, 6-4, and 6-7) that are star connected to form a polyphase circuit, and also at least one additional electric cable (6-2, 6-3, 6-5, 6-6, 6-8, and 6-9);
coupling the main cables at the pipeline head to an electricity generator (4);
coupling the main cables and the additional cable at the pipeline end to a common connection ring (10) arranged around the pipe and forming a point of zero electric potential; and
detecting any failure of the polyphase circuit in order to identify the failed main cable that has given rise to the failure of the polyphase circuit, and, where appropriate, replacing the failed main cable with the additional cable.

11. A method according to claim 10, wherein the additional cable of the polyphase circuit is connected to a neutral connection (N) of said polyphase circuit, a failure, if any, of the polyphase circuit being detected by means for monitoring the magnitude of the electric current flowing in the additional cable and forming a neutral conductor of the polyphase circuit.

12. A method according to claim 10, wherein the additional cable of the polyphase circuit is a spare cable that is electrically disconnected from said polyphase circuit, detection of a failure, if any, of the polyphase circuit comprising monitoring the magnitude of the electric current flowing in each of the main cables of the polyphase circuit.

13. A method according to any one of claims 10 to 12, further comprising electrically connecting the pipe at the pipeline end to the connection ring.
